# EUROPÄISCHE PATENTSCHRIFT

(11) **EP 0 403 887 B1**
(45) Veröffentlichungstag und Bekanntmachung des Hinweises auf die Patenterteilung: **28.04.1993**
(21) Anmeldenummer: 90110840.7
(22) Anmeldetag: 07.06.1990
(51) Int. Cl.: C30B 23/00, C30B 29/36

(54) **Verfahren zum Herstellen von einkristallinem Siliziumkarbid**
Process for producing single crystal silicon carbide
Procédé de production de carbure de silicium monocristallin

(30) Priorität: 20.06.1989 DE 3920134
(43) Veröffentlichungstag der Anmeldung: 27.12.1990
(73) Patentinhaber: SIEMENS AKTIENGESELLSCHAFT, 80333 München (DE)
(72) Erfinder: Stein, Rene, Dr., D-8551 Röttenbach (DE)

(56) Entgegenhaltungen:
- WO-A-89/04055
- DE-A- 3 230 727
- US-A- 4 556 436
- JOURNAL OF CRYSTAL GROWTH, Band 52, 1981, Amsterdam (NL); Y.M.TAIROV et al., Seiten 146-160#
- WORLD PATENTS INDEX, FILE SUPPLIER, AX=73-53107 U/47, Derwent Publications Ltd, London (GB)#

## Beschreibung

Die Erfindung bezieht sich auf ein Verfahren zum Herstellen von einkristallinem Siliziumkarbid SiC durch Sublimation und teilweises Zersetzen von technischen SiC-Kristallen in Pulverform. Bei diesem Verfahren läßt man die Einkristalle auf einem Keim in einem Reaktionsgefäß unter Schutzgas bei einem geringen Temperaturgradienten aufwachsen.

Einkristalle aus Siliziumkarbid können nach dem sogenannten Lely-Verfahren ohne Keimkristall durch Sublimation hergestellt werden. Dabei läßt man das Siliziumkarbid aus einer Verbindung aufwachsen, die teilweise mit in Kohlenstoff und Silizium angereichertem Dampf dissoziiert ist. Bei diesem Verfahren wird technisches Siliziumkarbid zersetzt und der Einkristall aus Siliziumkarbid wächst bei hoher Temperatur von etwa 2500°C.

Man kann die Einkristalle nach einem modifizierten Lely-Verfahren auch aus der Gasphase bei einer Temperatur von 2100 bis 2300°C auf einem Keimkristall aus Siliziumkarbid aufwachsen lassen. Dabei wird im Reaktionsgefäß in der Aufwachsrichtung ein Temperaturgradient von höchstens 25°C/cm eingehalten und der Druck des Schutzgases wird so eingestellt, daß er wenigstens so groß ist wie die Summe der Gasdrücke der Komponenten bei der Abscheidung (DE-PS 32 30 727).

Das bei diesem Verfahren verwendete technische SiC-Pulver wird im allgemeinen durch das sogenannte Acheson-Verfahren hergestellt, bei dem eine Mischung aus Siliziumdioxid SiO₂, Kohlenstoff und Zusätzen bei 2700°C in einem Ofen erwärmt wird. Als Heizelement dient ein in der Mitte der Wanne angeordneter Graphitkern. Durch Zusatz von Salz werden verschiedene Verunreinigungen umgewandelt in gasförmige Chloride, die aus dem Siliziumkarbid austreten. Man erhält somit verhältnismäßig reines Siliziumkarbid (Philips Research Reports, Bd. 18, Nr. 3, Juni 1963, Seiten 171 bis 174).

Für elektronische Bauelemente ist jedoch die Reinheit dieses sogenannten technischen Siliziumkarbids noch nicht ausreichend. Es enthält immer noch Spuren von Verunreinigungen, beispielsweise Schwermetallsilizide oder Karbide, die im Siliziumkarbid nicht homogen verteilt, sondern als Verunreinigungsnester einer zweiten Phase enthalten sind. Bei der Herstellung von Einkristallen kann es sogar zu Ausscheidungen von Verunreinigungen kommen, deren Löslichkeit im Kristall überschritten wird. Das als Ausgangsmaterial verwendete pulverförmige Siliziumkarbid wird deshalb noch einer chemischen Reinigung unterzogen, mit der die Verunreinigungskonzentration deutlich gesenkt werden kann.

Der Erfindung liegt nun die Aufgabe zugrunde, das Verfahren zum Herstellen von einkristallinem Siliziumkarbid durch Aufwachsen auf einem Keimkristall aus der Gasphase zu verbessern, insbesondere die Reinheit der hergestellten Einkristalle zu steigern.

Zur chemischen Reinigung des als Ausgangsmaterial verwendeten technischen Siliziumkarbids SiC können Säuren oder Laugen, insbesondere kann eine Mischung aus Flußsäure HF und Salpetersäure HNO₃, verwendet werden. Nach der Reinigung erfolgt eine Spülung in einer säure- und laugenfreien Flüssigkeit, vorzugsweise Wasser. Anschließend wird das Ausgangsmaterial getrocknet, vorzugsweise durch Erwärmen im Hochvakuum.

Die Erfindung beruht nun auf der Erkenntnis, daß für das Kristallwachstum ein Siliziumüberschuß vorhanden sein muß, und sie besteht in den kennzeichnenden Merkmalen des Anspruchs 1. Bei Verwendung von hochreinem Siliziumkarbid zum Herstellen des Siliziumkarbidkristalls, d.h. mit einem Gehalt an Verunreinigungen bis zu etwa 100 ppm, wird das elementare Silizium vor dem Kristallwachstum zugesetzt.

Bei der Verwendung von technischem Siliziumkarbid SiC als Ausgangsmaterial, das vor dem Kristallwachstum einer Reinigung unterzogen wird, setzt man das elementare Silizium nach der Reinigung zu. Bei der Reinigung kann nämlich freies Silizium oder Siliziumoxid oder Silicide gelöst werden und dadurch die Zusammensetzung der Gasphase, beispielsweise Si, Si₂C, SiC₂, geändert werden. Damit kann zugleich die Stöchiometrie des wachsenden Kristalls geändert und das Wachstum behindert werden. Durch den Zusatz von elementarem Silizium erhält man reine Einkristalle bis zu mehreren Zentimetern Länge. Vorzugsweise erfolgt ein Zusatz von 0,1 bis 5 %, insbesondere etwa 1 bis 2 % Silizium. Das elementare Silizium wird beispielsweise in Pulverform mit etwa der gleichen Körnung wie das SiC-Pulver, dessen Körnung etwa 10 bis 100 µm betragen kann, zugesetzt. Es kann aber auch mit einer verhältnismäßig großen Körnung, beispielsweise bis zu etwa 500 µm, oder sogar als ganzes Stück, beispielsweise als Scheibe, zugesetzt werden.

Eine dritte Möglichkeit, zum Kristallwachstum einen Überschuß an Silizium anzubieten, besteht darin, daß man das als Ausgangsmaterial verwendete SiC-Pulver bereits mit diesem Überschuß herstellt, d.h. daß beispielsweise Silizium Si und Kohlenstoff C in einem derartigen Mengenverhältnis gemischt werden, daß das molare Si:C-Verhältnis größer als 1 ist.

Die erhöhte Reinheit der gewachsenen Kristalle ist äußerlich durch erhöhte Transparenz und fehlende Schlieren erkennbar. Sie äußert sich ferner in besseren elektronischen Eigenschaften, wie beispielsweise einer erhöhten Beweglichkeit der Ladungsträger.

## Patentansprüche

1. Verfahren zum Herstellen von einkristallinem Siliziumkarbid SiC durch Sublimation und teilweises Zersetzen von kristallinem SiC-Pulver und Aufwachsen auf einem Keimkristall in einem Reaktionsgefäß unter Schutzgas bei einem geringen Temperaturgradienten, **dadurch gekennzeichnet**, daß zum Kristallwachstum ein Siliziumüberschuß im SiC-Pulver eingestellt wird.

2. Verfahren nach Anspruch 1, **dadurch gekennzeichnet,** daß bei Verwendung von hochreinem SiC-Pulver diesem SiC-Pulver vor dem Aufwachsen elementares Silizium zugesetzt wird.

3. Verfahren nach Anspruch 1, **dadurch gekennzeichnet**, daß bei Verwendung von technischem Siliziumkarbid SiC in Pulverform dieses SiC-Pulver vor dem Aufwachsen gereinigt und dann elementares Silizium zugesetzt wird.

4. Verfahren nach Anspruch 2 oder 3, **dadurch gekennzeichnet,** daß das Silizium in feinverteilter Form zugesetzt wird.

5. Verfahren nach Anspruch 1, **dadurch gekennzeichnet**, daß das als Ausgangsmaterial verwendete kristalline SiC-Pulver dadurch hergestellt wird, daß Silizium Si und Kohlenstoff C in einem derartigen Mengenverhältnis gemischt werden, daß das molare Si:C-Verhältnis größer als 1 ist.

## Claims

1. Process for the production of single-crystal silicon carbide SiC by sublimation and partial decomposition of crystalline silicon carbide powder and growing on a seed crystal in a reaction vessel under protective gas at a small temperature gradient, characterised in that for growing the crystal an excess of silicon is introduced in the silicon carbide powder.

2. Process according to claim 1, characterised in that when using highly pure silicon carbide powder elementary silicon is added to this silicon carbide powder before growing.

3. Process according to claim 1, characterised in that when using industrial silicon carbide SiC in powder form this silicon carbide powder is purified before growing and then elementary silicon is added.

4. Process according to claim 2 or 3, characterised in that silicon is added in finely dispersed form.

5. Process according to claim 1, characterised in that the crystalline silicon carbide powder used as starting material is produced by the silicon Si and carbon C being mixed together in a proportionate amount such that the molar Si: C ratio is greater than 1.

## Revendications

1. Procédé de préparation de carbure de silicium SiC monocristallin, par sublimation et par décomposition partielle de poudre de SiC monocristalline et par croissance sur un cristal germe dans un récipient de réaction sous gaz proctecteur et avec un faible gradient de température, caractérisé en ce qu'il consiste à établir pour la croissance du cristal un excès de silicium dans la poudre de SiC.

2. Procédé suivant la revendication 1, caractérisé en ce qu'il consiste, lorsque l'on utilise de la poudre de SiC très pure, à ajouter à cette poudre de SiC du silicium élémentaire avant la croissance.

3. Procédé suivant la revendication 1, caractérisé en ce qu'il consiste, lorsque l'on utilise du carbure de silicium SiC technique sous forme de poudre, à purifier cette poudre de SiC avant la croissance et à lui ajouter ensuite du silicium élémentaire.

4. Procédé suivant la revendication 2 ou 3, caractérisé en ce qu'il consiste à ajouter le silicium sous forme finement divisée.

5. Procédé suivant la revendication 1, caractérisé en ce qu'il consiste à préparer la poudre de SiC cristalline utilisée comme matière de départ en mélangeant le silicium Si et la carbone en un rapport quantitatif tel que le rapport molaire Si:C soit supérieur à 1.
